# EUROPEAN PATENT APPLICATION

(11) **EP 1 326 114 A1**
(43) Date of publication of application: **09.07.2003**
(21) Application number: 01958427.5
(22) Date of filing: 23.08.2001
(51) Int. Cl.: G02B 7/00, G02B 7/18, G02B 7/02, H01L 21/027, G03F 7/20

(54) **OPTICAL ELEMENT HOLDING DEVICE**

(30) Priority: 25.08.2000 JP 2000256203
(71) Applicant: Nikon Corporation, Tokyo 100-8331 (JP)
(72) Inventor: Nishikawa, Jin, c/o Nikon Corporation, Tokyo 100-8331 (JP)
(74) Representative: Reinhard - Skuhra - Weise & Partner GbR
(86) International application number: JP0107214
(87) International publication number: WO02016992

(57) **Abstract**

An optical element holding device (51) includes a holder (62) having a bearing surface (63) and a clamping member (64) for holding a flange (60a) of a lens (60), and a frame (61) coupled to a barrel (37). The holder holds the lens such that its optical axis (AX') is oriented in the horizontal direction. The holder is arranged such that a plane (P1) passing through its holding position and extending in a direction intersecting the optical axis of the lens substantially passes through the center of gravity (Gc) of the lens. The holder thus arranged stably holds the lens while preventing a moment of rotation from being produced, restrains deformation of optical surfaces of the lens, and maintains satisfactory optical performance.

## Description

### [Technical Field]

The present invention relates to an optical element holding device for holding an optical element, and more particularly to an optical element holding device for holding an optical element placed in a light path of exposure light in an exposure apparatus for use in a photolithography step in a process for manufacturing microdevices, such as semiconductor devices, liquid crystal display devices, imaging devices, and thin-film magnetic heads, or masks, such as reticles and photomasks. The present invention also relates to a barrel which contains the optical element holding device, and an exposure apparatus which has the barrel. The present invention further relates to a method of manufacturing a microdevice using the exposure apparatus.

### [Background Art]

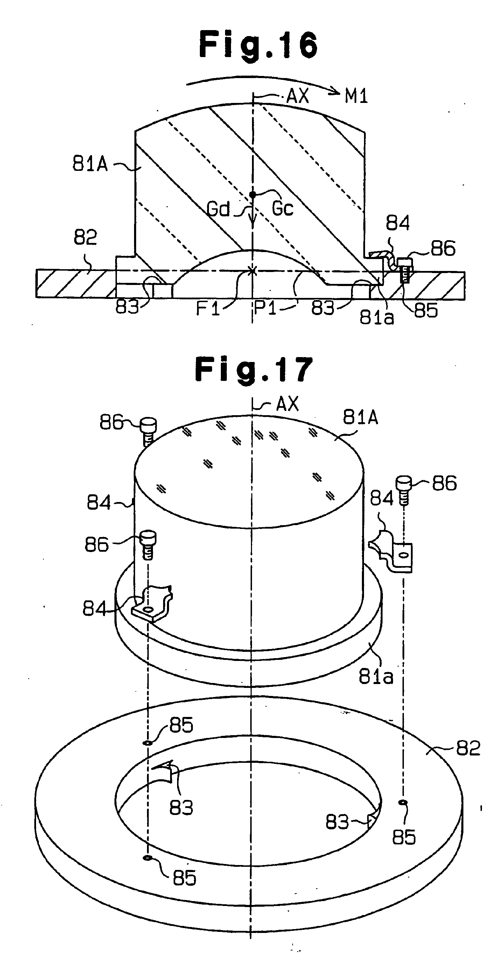

Known as this type of optical element holding device is what is configured to hold a lens 81A as an optical element such that its optical axis AX is oriented in the vertical direction (gravity direction), for example, as illustrated in Figs. 16 and 17. In this prior art configuration, a frame 82 for holding the lens 81A is formed in an annular shape. The frame 82 is formed with three bearing surfaces 83 formed on the inner peripheral surface at equal angular intervals, such that a flange 81a formed along the outer periphery of the lens 81A is supported on these bearing surfaces 83.

Three clamping members 84 are attached on the top surface of the frame 82 in correspondence to the respective bearing surfaces 83 at equal angular intervals with bolts 86 which are screwed into screw holes 85 on the frame 82. These bolts 86 are fastened to clamp the flange 81a of the lens 81A between the respective clamping members 84 and the bearing surfaces 83, thereby holding the lens 81A at a predetermined position in the frame 82.

However, in a catadioptric projection optical system or the like, for example, the lens 81A may be placed such that the optical axis AX is oriented in the horizontal direction or in an oblique direction which inclines at a predetermined angle with respect to the horizontal direction. In such a configuration, the gravity direction Gd of the lens 81A does not match the optical axis AX but is oriented in a direction which intersects the optical axis AX. Consequently, the optical system in this configuration causes the following problems.

Specifically, when the flange 81a of the lens 81A is held by clamping the same between the three clamping members 84 and the bearing surfaces 83, the clamping position (a plane P1 including three holding positions) separated from the center of gravity Gc of the lens 81A causes a moment of rotation M1 which is generated by the gravity of the lens 81A with a fulcrum F1 located at the intersection of the clamping position with the optical axis AX. This results in deformed lens surfaces and mirror surface, giving rise to a problem of exacerbated optical characteristics of the lens 81A and/or mirror, and an increase in various aberrations, such as wave front aberration and spherical aberration.

### [Disclosure of the Invention]

It is an object of the present invention to provide an optical element holding device which is capable of stably holding an optical element while limiting the moment produced in the optical element to restrain deformed optical surfaces of the optical element, thereby maintaining satisfactory optical performance.

The present invention provides a device for holding an optical element. The device includes a holder which holds the periphery of the optical element. The holder is configured to hold the optical element such that the optical axis of the optical element is oriented in the horizontal direction or in an oblique direction relative to horizontal, and such that a plane passing through a position for holding the optical element and extending in a direction intersecting the optical axis of the optical element substantially passes through the center of gravity of the optical element.

### [Brief Description of the Drawings]

Fig. 1 is a diagram schematically illustrating the configuration of a whole exposure apparatus;
Fig. 2 is a diagram schematically illustrating the configuration of a projection optical system and its surroundings in Fig. 1;
Fig. 3 is a cross-sectional view illustrating an optical element holding device according to a first embodiment of the present invention;
Fig. 4 is a side view of the optical element holding device in Fig. 3;
Fig. 5 is an exploded perspective view of the optical element holding device in Fig. 3;
Fig. 6 is a cross-sectional view illustrating an optical element holding device according to a second embodiment of the present invention;
Fig. 7 is an exploded perspective view of the optical element holding device in Fig. 6;
Fig. 8 is a perspective view illustrating an optical element in an optical element holding device according to a third embodiment of the present invention;
Fig. 9 is a perspective view of the optical element in Fig. 8 when seen from a different direction;
Fig. 10 is a side view illustrating an optical element holding device according to a fourth embodiment of the present invention;
Fig. 11 is a side view illustrating an optical element holding device according to a fifth embodiment of the present invention;
Fig. 12 is a side view illustrating an optical element holding device according to a sixth embodiment of the present invention;
Fig. 13 is a cross-sectional view illustrating an optical element holding device according to a seventh embodiment of the present invention;
Fig. 14 is a flow chart of an exemplary device manufacturing process;
Fig. 15 is a detailed flow chart of substrate processing in Fig. 14 for a semiconductor device;
Fig. 16 is a cross-sectional view illustrating a conventional optical element holding device; and
Fig. 17 is an exploded perspective view of the optical element holding device in Fig. 16.

### [Best Mode for Carrying out the Invention]

### (First Embodiment)

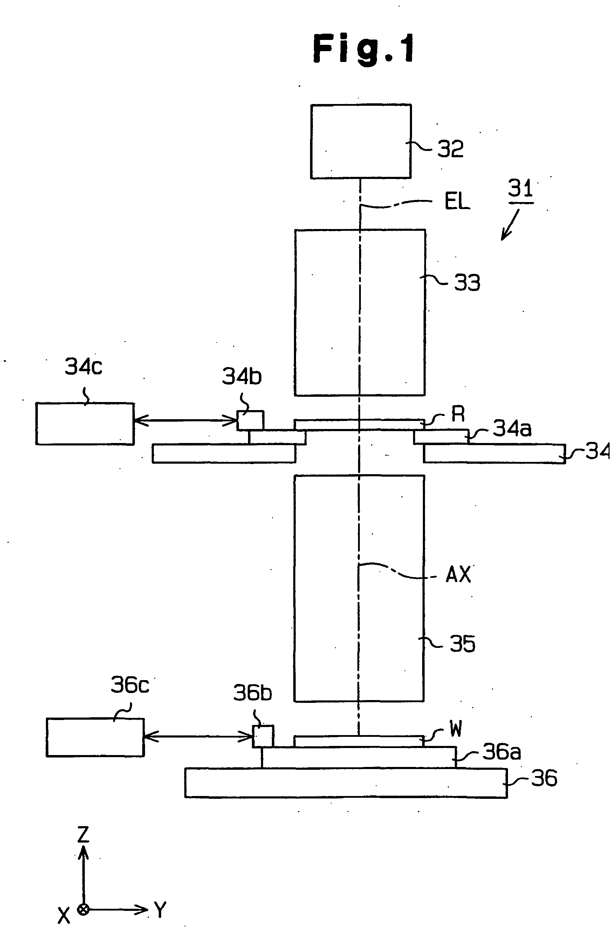

In the following, a first embodiment of the present invention will be described with reference to Figs. 1 to 5.

In the first embodiment, a so-called step-and-scan type scanning projection exposure apparatus includes a holding device which embodies an optical element holding device according to the present invention for holding an optical element (for example, a lens, a mirror, or the like) such that its optical axis is oriented in the horizontal direction or in an oblique direction which inclines at a predetermined angle with respect to the horizontal direction, and a projection optical system which embodies in part a barrel according to the present invention.

Fig. 1 schematically illustrates the configuration of a whole exposure apparatus which includes a catadioptric system as a projection optical system. In Fig. 1, the Z-axis is set in parallel with a reference optical axis AX of the catadioptric system which comprises a projection optical system 35; the Y-axis is set in parallel with the sheet surface of Fig. 1 within a plane perpendicular to the optical axis AX; and the X-axis is set perpendicular to the sheet surface, respectively.

This exposure apparatus 31 includes, for example, an F₂ laser (having an oscillation center wavelength of 157.624 nm) as a light source 32 for supplying exposure light EL in an ultraviolet region. The exposure light EL emitted from the light source 32 uniformly illuminates a reticle R formed with a predetermined pattern thereon through an illumination optical system 33. A light path between the light source 32 and the illumination optical system 33 is hermetically sealed in a casing (not shown). Then, the space from the light source 32 to the optical element closest to the reticle R within the illumination optical system 33 is replaced with an inert gas such as a helium gas, nitrogen or the like, which exhibits a low absorption factor for the exposure light EL, is maintained substantially in a vacuum state.

The illumination optical system 33 includes a beam shaping optical system; a fly-eye lens or a rod lens as an optical integrator; aperture stops of illumination system disposed on an exit surface of the fly-eye lens; a reticle blind having an opening which forms a straight slit extending in a direction perpendicular to a scanning exposure direction; and a condenser lens for irradiating the reticle R with exposure light formed in a slit shape by the reticle blind. The aperture stops includes a circular aperture stop for normal illumination; an aperture stop for transformed illumination consisting of a plurality of small openings eccentric from the optical axis; and a circular aperture stop for annular illumination. The stops are selectively disposed on the exit surface of the fly-eye lens.

The reticle R is held by a reticle holder 34a such that a pattern surface formed on the reticle R is in parallel with an XY-plane on a reticle stage 34. The pattern surface of the reticle R is formed with a pattern which is to be transferred onto a wafer W. The aforementioned illumination optical system 33 illuminates the reticle R with a rectangular (slit-shaped) illumination region which has long sides in the X-direction and short sides in the Y-direction within the entire pattern region. The reticle stage 34 is two-dimensionally movable along the pattern surface (i.e., the XY-plane) by the action of a driving system, not shown. The coordinates at which the reticle stage 34 is positioned can be found by an interferometer 34c which measures the position of a mirror 34b disposed on the reticle stage 34, so that the reticle stage 34 is controlled in terms of the position based on the result of the measurement.

The light from the pattern formed on the reticle R is led to the wafer W, which is a photo-sensitive substrate, through the catadioptric type projection optical system 35. The wafer W is held on the wafer stage 36 through a wafer table (wafer holder) 36a. Then, a pattern image is formed in a rectangular exposure region having the long sides in the X-direction and the short sides in the Y-direction on the wafer W, so as to optically correspond to the rectangular illumination region on the reticle R. The wafer stage 36 is two-dimensionally movable along a wafer surface (i.e., the XY-plane) by the action of a driving system, not shown. The coordinates at which the wafer stage 36 is positioned can be found by an interferometer 36c which measures the position of a mirror 36b disposed on the wafer stage 36 or the wafer holder 36a, so that the wafer stage 36 is controlled in terms of the position based on the result of the measurement.

The illustrated exposure apparatus 31 is configured such that an air-tight state is held within the projection optical system 35 between the optical element located closest to the reticle R and the optical element (lens L1 in this embodiment) located closest to the wafer W. The projection optical system 35 comprised of the optical element located closest to the reticle R and the optical element located closest to the wafer W. Then, a gas within the projection optical system 35 is replaced with an inert gas such as a helium gas, nitrogen or the like, or maintained substantially in a vacuum state.

The reticle R and the reticle stage 34 are disposed on a narrow light path between the illumination optical system 33 and the projection optical system 35. These reticle R and the reticle stage 34 are hermetically sealed in a casing (not shown), and the casing is filled with an inert gas such as nitrogen, helium gas or the like, or maintained substantially in a vacuum state.

The wafer W, wafer stage 36 and the like are disposed on a narrow light path between the projection optical system 35 and the wafer stage 36. These wafer W, wafer stage 36 and the like is hermetically sealed in a casing (not shown), and the casing is filled with an inert gas such as nitrogen, helium gas or the like, or maintained substantially in a vacuum state.

This results in the formation of an atmosphere in which the exposure light EL is hardly absorbed along the overall light path from the light source 32 to the wafer W.

As described above, the illumination region on the reticle R and the exposure region on the wafer W, defined by the illumination optical system 33, are in the shape of a rectangle which has the short sides in the Y-direction. Therefore, the reticle stage 34 and the wafer stage 36, and hence the reticle R and the wafer W are moved (scanned) in synchronism in the same direction (i.e., to the same orientation) in the direction of the short sides of the rectangular exposure region and illumination region, i.e., the Y-direction, while the driving system, interferometers 34c, 36 and the like are used to control the positions of the reticle R and the wafer W. Consequently, the reticle pattern is scanned on the wafer W to expose a region having a width equal to the long sides of the exposure region and having a length corresponding to the amount by which the wafer W is scanned (amount of movement).

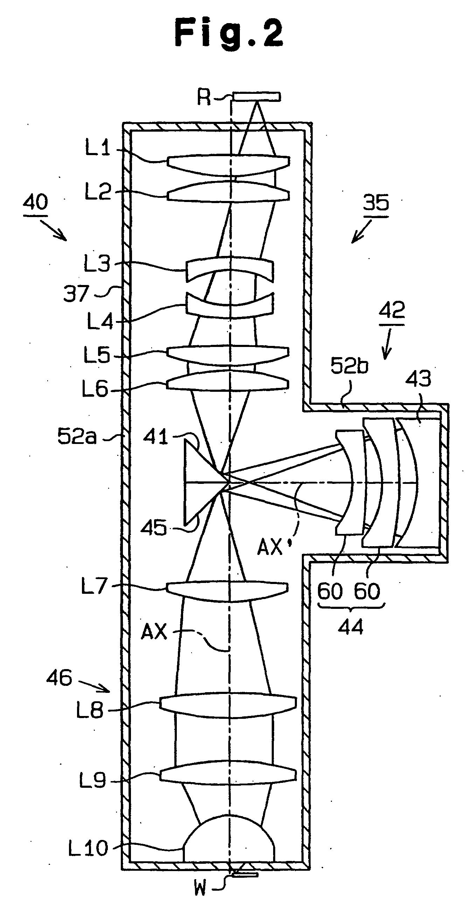

Next, Fig. 2 is a diagram for describing the basic configuration of the projection optical system 35 contained in a barrel 37. All refractive optical element (lens components) comprising the projection optical system 35 are made of fluorite (CaF₂ crystals). As illustrated in Fig. 2, the catadioptric system of the present invention includes a first focusing optical system 40 of refractive type for forming a first intermediate image of the pattern on the reticle R disposed on a first plane (physical plane of the projection optical system). The first focusing optical system 40 is composed of a group of lenses L1, L2, L3, L4, L5, and L6.

A first light path bending mirror 41 is disposed near the position at which the first intermediate image is formed by the first focusing optical system 40. When the first intermediate image is formed by the first focusing optical system 40 at a position between the first focusing optical system 40 and the first light path bending mirror 41, the first light path bending mirror 41 deflects light flux from the first intermediate image toward a second focusing optical system 42. In addition, when the first intermediate image is formed by the first focusing optical system 40 at a position between the first light path bending mirror 41 and the second focusing optical system 42, the first light path bending mirror 41 deflects light flux focused by the first focusing optical system 40 toward the second focusing optical system 42. The second focusing optical system 42 has a concave reflective mirror 43, and a group of lenses 44 composed of at least one minus lens for forming a second intermediate image (which is an image of the first intermediate image and a secondary image of the pattern) substantially equal in size to the first intermediate image near the position at which the first intermediate image is formed, based on the light flux from the first intermediate image. These concave reflective mirror 43 and lens group 44 are vertically disposed such that their optical axis AX' is oriented in the horizontal direction. In the following, the lens group 44 is called the "vertically disposed lens group."

A second light path bending mirror 45 is disposed near the position at which the second intermediate image is formed by the second focusing optical system 42. When the second intermediate image is formed by the second focusing optical system 42 at a position between the second focusing optical system 42 and the second light path bending mirror 45, the second light path bending mirror 45 deflects light flux from the second intermediate image toward a third focusing optical system 46. Further, when the second intermediate image is formed by the second focusing optical system 42 at a position between the second light path bending mirror 45 and the third focusing optical system 46, the second light path bending mirror 45 deflects light flux focused by the second focusing optical system 42 toward the third focusing optical system 46. Here, the reflecting surface of the first light path bending mirror 41 is spatially isolated from the reflecting surface of the second light path bending mirror 45. In other words, the configuration is designed such that the light flux reflected by the first light path bending mirror 41 is not directly led to the second light path bending mirror 45 while the light flux reflected by the second light path bending mirror 45 is not directly led to the first light path bending mirror 41.

The first light path bending mirror 41 and the second light path bending mirror 45 may be formed of members independent of each other, or the first light path bending mirror 41 and the second light path bending mirror 45 may be simultaneously formed in a single member.

The third focusing optical system 46 forms a reduced image of the pattern on the reticle R (which is an image of the second intermediate image and a final image of the catadioptric system) on the wafer W placed on a second plane (image plane of the projection optical system) based on the light flux from the second intermediate image. The third focusing optical system 46 is composed of a group of lenses L7, L8, L9, and L10.

The barrel 37 includes a first barrel section 52a for containing the first focusing optical system 40 and the third focusing optical system 46, and a second barrel section 52b for containing the second focusing optical system 42.

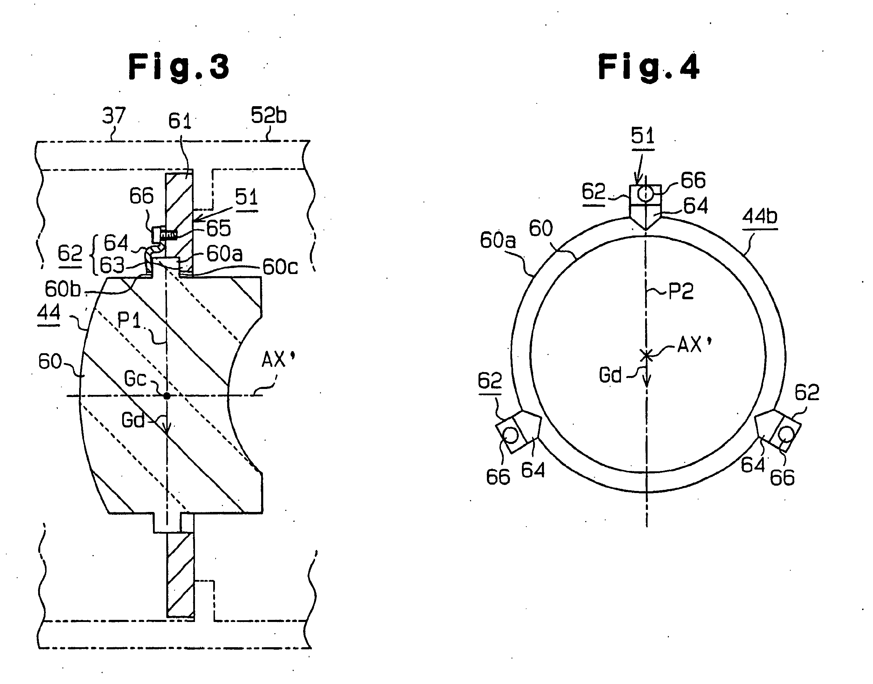

Next, detailed description will be provided for the configuration of an optical element holding device 51 in connection with Figs. 3-5, according to the first embodiment for holding the vertically disposed lens group 44 of the second focusing optical system 42.

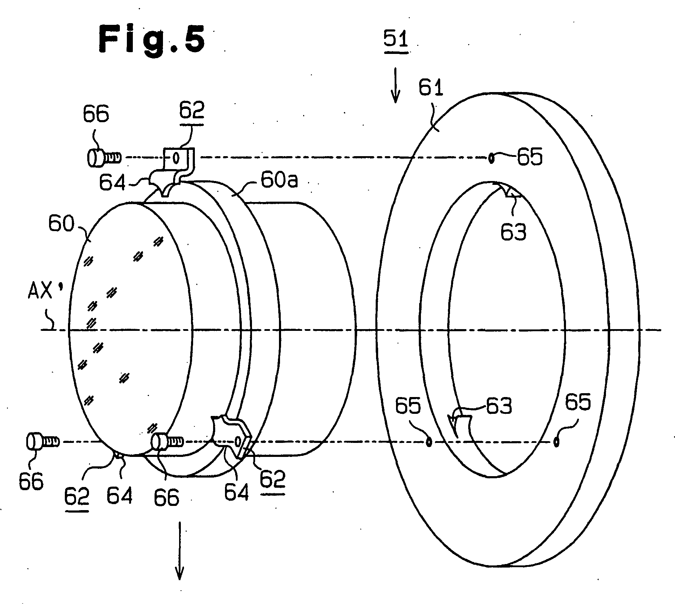

In that regard, Fig. 3 illustrates a cross-sectional view of the optical element holding device 51 according to the first embodiment, Fig. 4 illustrates a side view of the optical element holding device 51 when seen from the direction of the optical axis AX' of the vertically disposed lens group 44, and Fig. 5 illustrates an exploded perspective view of the optical element holding device 51 according to the first embodiment.

As illustrated in Figs. 3 to 5, a flange 60a is formed along the outer peripheral surface of a lens 60 which is an optical element forming part of the vertically disposed lens group 44. The flange 60a corresponds to the position at which the lens 60 is held. The flange 60a includes a plane P1 which includes the center of gravity Gc of the lens 60 when it is vertically disposed. The plane P1 is substantially perpendicular to the optical axis AX' of the lens 60, and extends in the gravity direction. The flange 60a also includes parallel flange surfaces 60b and 60c at positions spaced by the same distance from the plane P1.

The optical element holding device 51 includes a frame 61 which is a coupler coupled to the second barrel 52b; and three holders 62 disposed on the frame 61 at equal angular intervals. Thus, the flange 60a of the lens 60 is held in these holders 62.

Specifically, the frame 61 is formed of a metal material such as aluminum in an annular shape, and is formed with three bearing surfaces (see Fig. 5), including the holders 62, formed on the inner peripheral surface at equal angular intervals. In correspondence to the respective bearing surfaces 63, three clamping members 64, comprising the holders 62, are attached on one side of the frame 61 at equal angular intervals with bolts 66 which are threaded into screw holes 65 on the frame 61.

The bolts 66 are fastened to clamp the flange 60a of the lens 60 between the respective clamping members 64 and the bearing surfaces 63, thereby holding the lens 60 in the frame 61. In addition, as the frame 61 is assembled into the horizontal barrel 52 of the barrel 37 in this state, the lens 60 is held with its optical axis AX' oriented in the horizontal direction.

In this event, as illustrated in Fig. 3, when the three holders 62 hold the flange 60a of the lens 60, respectively, the plane P1 positioned halfway between the flange surfaces 60b and 60c is arranged in the same direction as the gravity direction Gd through the center of gravity Gc of the lens 60. This plane P1 is perpendicular to the optical axis AX' of the lens 60. Thus, unlike the conventional configuration which causes misregistration between the plane P1 at an intermediate position of the flange 60a and the center of gravity Gc of the lens, no moment of rotation will be produced in the lens 60 due to the gravity acting on the lens 60. Consequently, the lens 60 is prevented from deformation of the lens surfaces and resultant impairment of the optical performance thereof (for example, various aberration such as wave front aberration and spherical aberration).

While the first embodiment has been described on the assumption that the intermediate position exists between the clamping member 64 and the bearing surfaces 63, i.e., between the flange surfaces 60b and 60c, the plane P1 may not exist at the intermediate position between the flanges 60b and 60c. For example, the plane P1 may be located at a position including the flange surface 60b of the flange 60a, which is in contact with the clamping members 64, or the plane P1 may be located at a position including the flange surface 60c of the flange 60a which is in contact with the bearing surfaces 63.

The holding position may be a position including the clamping members 64 and the bearing surfaces 63 as well as the position including the flange surfaces 60b and 60c of the flange 60a.

When the lens 60 is held, the three holders 62 are disposed at positions rotationally symmetric about the optical axis AX' of the lens 60 at substantially equal angular intervals along the periphery of the lens 60, as shown in Fig. 4. In addition, the three holders 62 are disposed at positions symmetric to a plane P2 which includes the optical axis AX' of the lens 60 and extends in the gravity direction Gd. In other words, one upper holder 62 is disposed on the plane P2, while the two remaining holders 62 are disposed at positions symmetric to the plane P2. In this way, the lens 60 is stably held without deviation.

Thus, the first embodiment provides the following advantages.
(A) In the optical element holding device 51, the respective holders 62 hold the flange 60a of the lens 60 such that the plane P1 included in the holding position passes through the center of gravity Gc.
   For this reason, the plane P1 included in the holding position of the holders 62 is set to pass through the center of gravity Gc of the lens 60 without being biased from the center of gravity Gc, so that the lens 60 can be stably held without producing a moment of rotation. It is therefore possible to restrain deformation of the optical surfaces of the lens 60 due to the absence of the moment to maintain satisfactory optical performance.
(B) In the optical element holding device 51, the three holders 62 are disposed at positions rotationally symmetric to the optical axis AX' of the lens 60 at substantially equal angular intervals along the periphery of the lens 60. Thus, the lens 60 can be more stably held by the three holders 62 disposed at the positions rotationally symmetric to the optical axis AX' at substantially equal angular intervals.
(C) In the optical element holding device 51, the three holders 62 are disposed at positions symmetric to the plane P2 which includes the optical axis AX' of the lens 60 and extends in the gravity direction Gd. Thus, the lens 60 can be more stably held by the three holders 62 disposed at the positions symmetric to the plane P2 which includes the optical axis AX' of the lens 60 and extends in the gravity direction Gd.
(D) In the exposure apparatus 31, the vertically disposed lens group 44, which is contained in the second barrel 52b of the barrel 37 in a vertically disposed configuration, is held by the optical element holding device 51 which has the foregoing advantages (A) to (C).

It is therefore possible to stably hold the vertically disposed lens group 44 while preventing the occurrence of the moment. Thus, satisfactory optical performance can be maintained for the projection optical system 35 to improve an exposure accuracy. Then, the use of the exposure apparatus 31 permits highly integrated semiconductor devices to be manufactured in good yield.

### (Second Embodiment)

Next, a second embodiment of the present invention will be described, mainly concentrating on differences from the first embodiment.

In the second embodiment, detailed description will be provided for the configuration of an optical element holding device 69 for holding a concave reflective mirror 43 which is disposed vertically in the second focusing optical system such that the optical axis AX' is oriented in the horizontal direction.

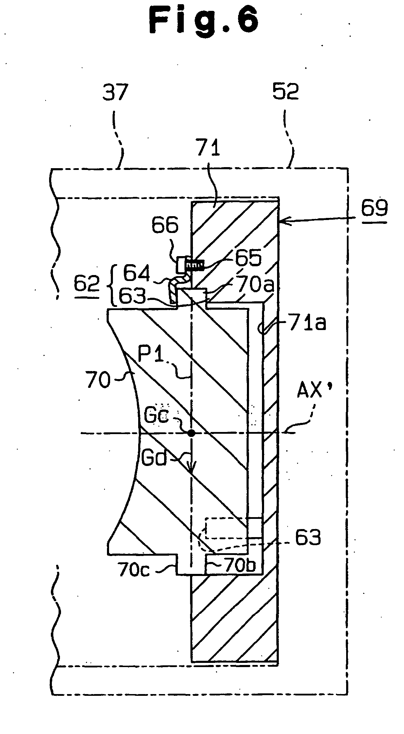

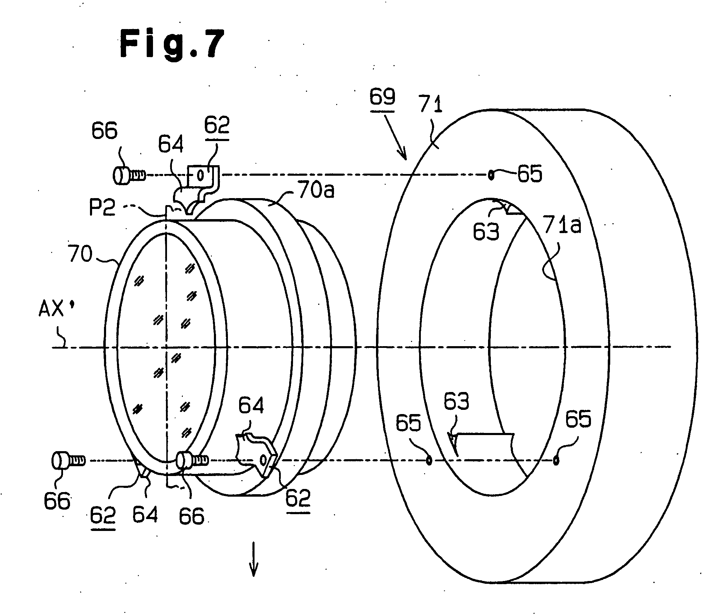

Fig. 6 illustrates a cross-sectional view of the optical element holding device 69 according to the second embodiment, and Fig. 7 illustrates an exploded perspective view of the optical element holding device 69 according to the second embodiment.

As illustrated in Figs. 6 and 7, a mirror 70, which is an optical element forming part of the concave reflective mirror 43, is formed with a flange 70a on the outer peripheral surface. The flange 70a includes a plane P1 which includes the center of gravity Gc of the mirror 70, when the mirror 70 is vertically disposed. The plane P1 is substantially perpendicular to the optical axis AX' of the mirror 70 and extends in the gravity direction. The flange 70a has flange surfaces 70b, 70c parallel with each other at positions spaced by the same distance from the plane P1.

The optical element holding device 69 has a frame 71 formed of a metal material such as aluminum in a disk shape. A circular recess 71a is formed at the center of one side surface of the frame 71 for containing the mirror 70. Three bearing surfaces 63, which comprise holders 62, are formed at equal angular intervals on the inner peripheral surface of the recess 71a of the frame 71, while three clamping members 64, which comprise the holders 62, are attached on one side surface of the frame 71 with bolts 66. The frame 71 has the other side surface coupled to the barrel 37 by a predetermined coupling mechanism (bolts or the like).

Similar to the first embodiment, the respective holders 62 hold the flange 70a of the mirror 70 such that the plane P1 included in the respective holding positions of the respective holders 62 passes through the center of gravity Gc of the mirror 70. Also, the frame 71 is assembled into the barrel 37 in this state, thereby holding the mirror 70 such that the optical axis AX' thereof is oriented substantially in the horizontal direction (vertically disposed configuration).

Again, similar to the first embodiment, the respective holders 62 hold the flange 70a of the mirror 70 such that the plane P1 included in the respective holding positions of the respective holders 62 passes through the center of gravity Gc of the mirror 70. Also, the three holders 62 are disposed at positions rotationally symmetric to the optical axis AX' of the mirror 70 at substantially equal angular intervals along the periphery of the mirror 70. Further, out of the three holders 62, the upper holder 62 is disposed on a plane P2 which includes the optical axis AX' of the mirror 70 and extends in the gravity direction Gd, while the two remaining holders 62 are disposed at positions symmetric to the plane P2.

Accordingly, the second embodiment can also provide substantially similar advantages to those described in (A) to (C) for the first embodiment.

### (Third Embodiment)

Next, a third embodiment of the present invention will be described, mainly concentrating on differences from the second embodiment.

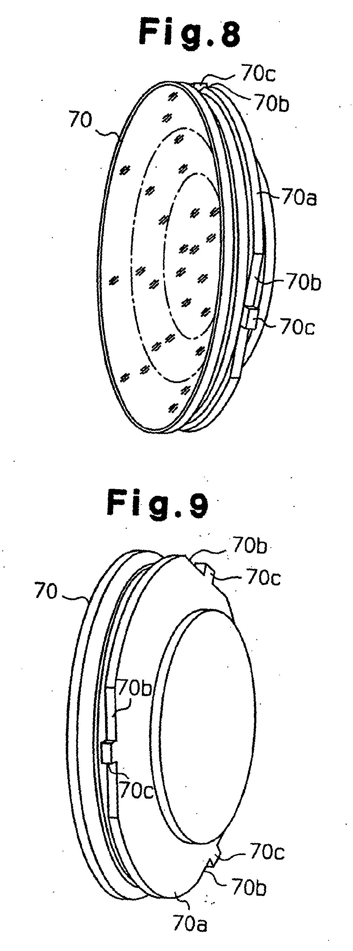

In the third embodiment, as illustrated in Figs. 8 and 9, a mirror 70, as an optical element, is made of a ceramic, and is formed with a flange 70a on the outer peripheral surface. The flange 70a includes three notches 70b formed on the peripheral surface at equal angular intervals. A protrusion 70c is formed at the center of each notch 70b.

Similar to the second embodiment, three holders 62 each having a bearing surface 63 and a clamping member 64 are disposed on a frame 71 of an optical element holding device 69. Then, both sides of the protrusion 70c is clamped between the clamping member 64 and the bearing surface 63 of each of the holders 62, thereby holding the mirror 70 within the frame 71. In addition, both sides of the protrusion 70c in the tangential direction may be clamped other than both sides of the protrusions 70C clamped by the clamping members 64 and the bearing surfaces 63.

Again, similar to the second embodiment, the respective holders 62 hold the flange 70a of the mirror 70 such that a plane P1 including respective holding positions of the respective holders 62 passes through the center of gravity Gc of the mirror 70. Also, the respective holders 62 are disposed at positions rotationally symmetric to the optical axis AX' of the mirror 70 and at substantially equal angular intervals. Further, out of the holders 62, the upper holder 62 is disposed on the plane P2, while the two remaining holders 62 are disposed at positions symmetric to the plane P2.

Accordingly, the third embodiment can also provide substantially similar advantages to those described in (A) to (C) for the first embodiment.

### (Fourth Embodiment)

Next, a fourth embodiment of the present invention will be described, mainly concentrating on differences from the first embodiment.

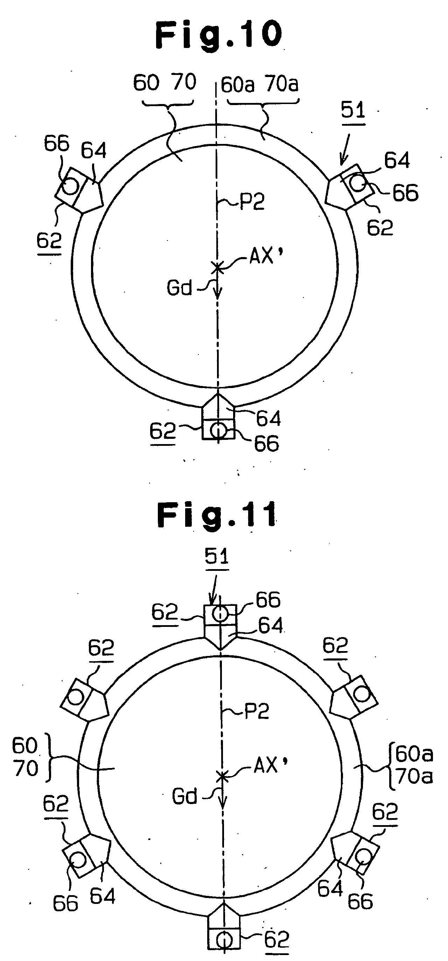

In the fourth embodiment, as illustrated in Fig. 10, out of three holders 62 of an optical element holding device 51, a lower holder 62 is disposed on a plane P2 which includes the optical axis AX' of a lens 60 or a mirror 70 and extends in the gravity direction Gd. Then, the two remaining holders 62 are disposed at positions symmetric to the plane P2.

Accordingly, the fourth embodiment can also provide substantially similar advantages to those described in (A) to (C) for the first embodiment.

### (Fifth Embodiment)

Next, a fifth embodiment of the present invention will be described, mainly concentrating on differences from the first embodiment.

As illustrated in Fig. 11, in an optical element holding device 51 according to the fifth embodiment, six holders 62 are disposed at predetermined angular intervals on the periphery of a lens 60 or a mirror 70. Then, out of the six holders 62, a pair of upper and lower holders 62 are disposed on a plane P2 which includes the optical axis AX' of the lens 60 or mirror 70 and extends in the gravity direction Gd, while the four remaining holders 62 are disposed at positions symmetric to the plane P2.

Accordingly, the fifth embodiment can also provide substantially similar advantages to those described in (A) to (C) for the first embodiment.

### (Sixth Embodiment)

Next, a sixth embodiment of the present invention will be described, mainly concentrating on differences from the first embodiment.

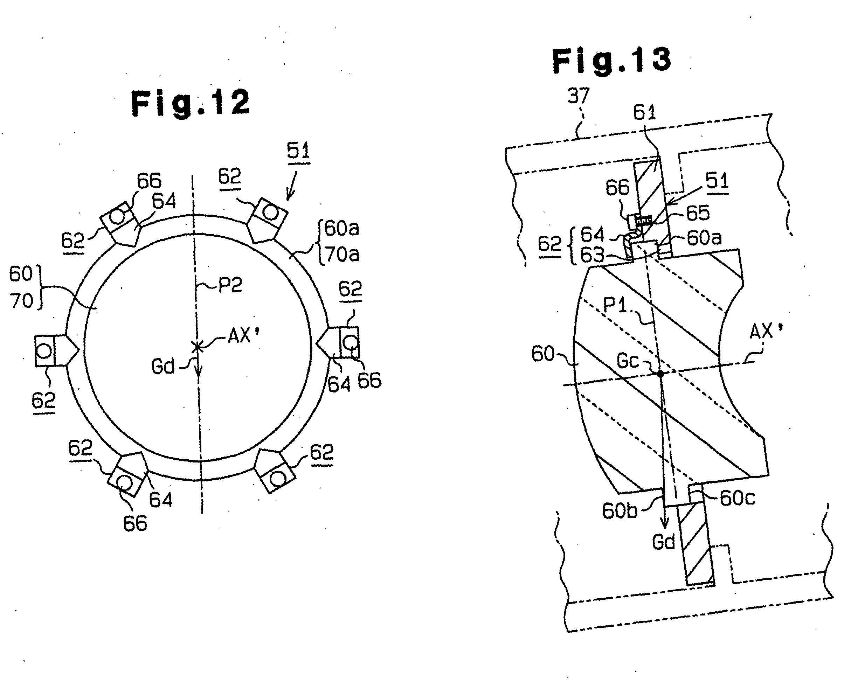

As illustrated in Fig. 12, in an optical element holding device 51 according to the sixth embodiment, six holders 62 are likewise disposed at predetermined angular intervals on the periphery of a lens 60 or a mirror 70. Out of the six holders 62, three holders 62 each are disposed at positions symmetricaooy6 opposite one another relative to a plane P2 which includes the optical axis AX' of the lens 60 or mirror 70 and extends in the gravity direction Gd.

Accordingly, the sixth embodiment can also provide substantially similar advantages to those described in (A) to (C) for the first embodiment.

### (Seventh Embodiment)

Next, a seventh embodiment of the present invention will be described, mainly concentrating on differences from the first embodiment.

As illustrated in Fig. 13, in the seventh embodiment, a lens 60 is held by holders 62 of an optical element holding device 51, and assembled into a barrel 37 through a frame 61, wherein the optical axis AX' of the lens 60 is oriented in an oblique direction which inclines by a predetermined angle with respect to the horizontal direction (obliquely disposed configuration). Specifically, in this state, a plane P1 which is included in holding positions of the holders 62 and extends in a direction perpendicular to the optical axis AX' of the lens 60 inclines by the predetermined angle with respect to the gravity direction Gd which passes through the center of gravity Gc of the lens 60.

However, when the gravity direction Gd is along the holding positions, i.e., between flange surfaces 60b and 60c, the lens 60 can be before prevented from deformation of optical surfaces thereof than the conventional structure for holding an optical element. Therefore, in the obliquely disposed configuration, even if the optical axis AX' of the lens 60 inclines at a large angle with respect to the horizontal direction, the flange 60a may be formed such that the gravity direction Gd is between the flange surfaces 60b and 60c.

The seventh embodiment may support not only the lens 60 but also the concave reflective mirror described in the second and third embodiments.

The optical element holding device 51 for supporting the obliquely disposed lens 60 or mirror in the foregoing manner can be used, for example, in a catadioptric system, as described in Japanese Laid-Open Patent Publication No. 2000-47114.

Accordingly, the seventh embodiment can also provide substantially similar advantages to those described in (A) to (C) for the first embodiment.

### (Exemplary Modifications)

While the respective embodiments have illustrated three or six holders 62 disposed on the periphery of the lens 60 or mirror 70, the number of the holders 62 may be changed to four, five, or seven or more.

While in the respective embodiments, the holder 62 comprises the bearing surface 63 and the clamping member 64, the holder 62 may be modified to hold an optical element using another clamping mechanism, an adhesive, brazing, or the like.

In the second embodiment, the mirror 70 is held with its optical axis AX' oriented in the horizontal direction. Alternatively, as in the seventh embodiment illustrated in Fig. 13, the mirror 70 may be held such that its optical axis AX' is oriented in an oblique direction which inclines at a predetermined angle with respect to the horizontal direction.

While the respective embodiments have illustrated each of the lens 60 and the mirror 70 as optical element, the optical element may be another optical element such as a parallel flat plate. In addition, the optical element may be a flat reflective mirror as well as a concave reflective mirror.

The optical element holding device 51 according to the present invention is not limited to a device for holding a vertically disposed optical element in the projection optical system 35 of the exposure apparatus 31 in the forgoing embodiments, but may be embodied in a device for holding a vertically disposed optical element in another kind of optical system of the exposure apparatus 31, for example, an illumination optical system. Further, the present invention may be embodied in a device for holding an optical element in an optical system of another optical equipment, for example, a microscope or interferometer.

Even in the foregoing cases, substantially similar advantages can be provided as in the respective embodiments described above.

The projection optical system 35 of the exposure apparatus 31 is not limited to a catadioptric type, but may be a total refractive type in which a projection optical system has an optical axis inclined with respect to the gravity direction.

The light source 32 is not limited to F₂ laser light for supplying pulsed light at a wavelength of 157 nm, but may be implemented by a KrF excimer laser for supplying light at a wavelength of 248 nm, an ArF excimer laser for supplying light at a wavelength of 193 nm, or an Ar₂ laser for supplying light at a wavelength of 126 nm. Single wavelength laser light in an infrared region or in an oscillated visible light region from a DFB semiconductor laser or a fiber laser may be amplified by a fiber amplifier doped, for example, with erbium (or both erbium and ytterbium), and converted to ultraviolet light using a non-linear optical crystal, and resulting harmonics may be used.

The present invention can be applied not only to an exposure apparatus for manufacturing microdevices such as semiconductor devices but also to an exposure apparatus for transferring a circuit pattern from a mother reticle to a glass substrate, a silicon wafer or the like for manufacturing a reticle or a mask for use with an optical exposure apparatus, an EUV exposure apparatus, an X-ray exposure apparatus, and an electron beam exposure apparatus. Here, an exposure apparatus which uses DUV (deep ultraviolet) or VUV (vacuum ultraviolet) light or the like generally employs a transmission type reticle, wherein a reticle substrate is made of a quartz glass, quartz glass doped with fluorine, fluorite, magnesium fluoride, crystal, or the like. On the other hand, a proximity type X-ray exposure apparatus and electron beam exposure apparatus employ a reflection type mask (stencil mask and membrane mask), wherein a mask substrate is made of a silicon wafer or the like.

Needless to say, the present invention can be applied not only to exposure apparatus for use in manufacturing semiconductor devices but also to an exposure apparatus for use in manufacturing displays including a liquid crystal display (LCD) device for transferring a device pattern onto a glass plate, an exposure apparatus for use in manufacturing thin-film magnetic heads for transferring a device pattern onto a ceramic wafer, and/or an exposure apparatus for use in manufacturing image pickup devices such as a CCD.

While the foregoing embodiments have been described in connection with a scanning stepper to which the present invention is applied, the present invention can also be applied to a step-and-repeat type exposure apparatus which is adapted to transfer a pattern on a mask onto a substrate, while the mask and the substrate are kept stationary, and sequentially move the substrate in steps.

In the foregoing embodiments, the catadioptric projection system has a reduction scaling factor for projection. However, not limited to the reduction scaling factor, the catadioptric projection system may have an equal or enlargement scaling factor. For example, for projection at an enlargement scaling factor, light is entered from the third focusing optical system 46, which forms a primary image of the mask or reticle R. Then, the second focusing optical system 42 forms a secondary image, and the first focusing optical system 40 forms a ternary image (final image) on a substrate such as a wafer W.

At least some of a plurality of lenses or mirrors, which comprise the illumination optical system 33 and the projection optical system 35, are held by the optical element holding devices 51 and 69 in the respective embodiments. The illumination optical system 33 and the projection optical system 35 are assembled into the body of the exposure apparatus 31 and subjected to optical adjustments. The wafer stage 36 (including the reticle stage 34 when the exposure apparatus is of a scanning type) composed of a large number of mechanical parts is mounted in the exposure apparatus 31 with its wires being connected, and a gas supply pipe is connected for supplying a gas into the light path for the exposure light EL. After completion of adjustments (electric adjustments and operational verification) are made, the exposure apparatus 31 in the embodiment can be manufactured.

The parts which comprise the optical element holding device 51 are assembled after impurities such as working oil, metal materials and the like have been removed therefrom through ultrasonic washing or the like. The exposure apparatus 31 is preferably manufactured in a clean room which has controlled temperature, humidity and atmospheric pressure as well as adjusted cleanness.

While fluorite has been given as an example of a glass material in the embodiments, the optical element holding device 51 of the embodiments can also used for holding crystals such as quartz, lithium fluoride, magnesium fluoride, strontium fluoride, lithium-calcium-aluminum-fluoride, and lithium-strontium-aluminum-fluoride, glass fluoride comprised of zirconium-barium-lanthanum-aluminum, or modified quartz such as fluorine doped quartz glass, quartz glass doped with hydrogen in addition to fluorine, OH-base containing quartz glass, and fluorine and OH-base containing quartz glass.

Next, description will be provided for a method of manufacturing a device using the aforementioned exposure apparatus 31 using lithography.

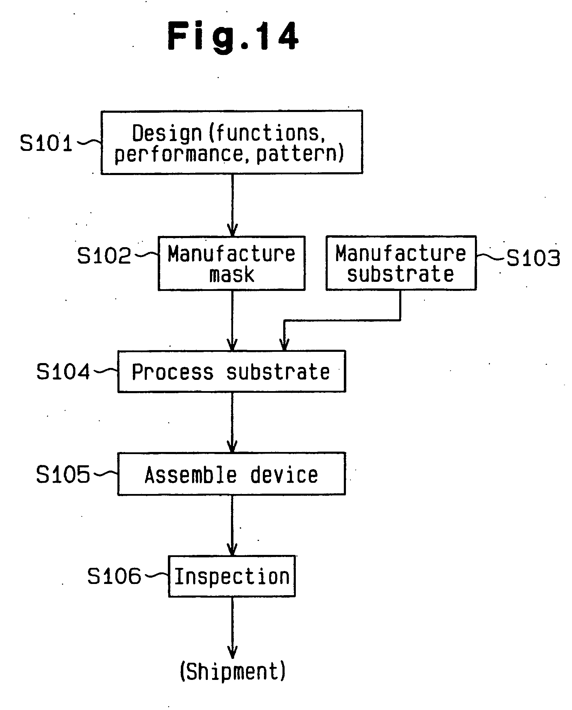

Fig. 14 is a flow chart illustrating an exemplary process for manufacturing a device (a semiconductor chip such as IC, LSI or the like, a liquid crystal panel, a CCD, a thin-film magnetic head, and a micromachine). As illustrated in Fig. 14, first, in step S101 (designing step), the device (microdevice) is designed for its functions and performance (for example, designing of circuits in a semiconductor device), and a pattern is designed for implementing the functions. Subsequently, in step S102 (mask manufacturing step), a mask formed with the designed circuit pattern (reticle R, photomask, or the like) is manufactured. On the other hand, in step S103 (substrate manufacturing step), a substrate (wafer W, glass plate, or the like) is manufactured using a material such as silicon, glass, or the like.

Next, in step S104 (substrate processing step), an actual circuit and the like are formed on the substrate by a lithographic technique or the like, as described below, using the mask and the substrate prepared in steps S101 to S103. Next, in step S105 (device assembling step), the device is assembled using the substrate which has been processed in step S104. This step S105 includes, as required, steps such as dicing, bonding, and packaging (chip encapsulation).

Finally, in step S106 (inspection step), the device fabricated in step S105 is inspected for verification of device operability, durability, and the like. The device is completed and shipped out only after the foregoing steps have been completed.

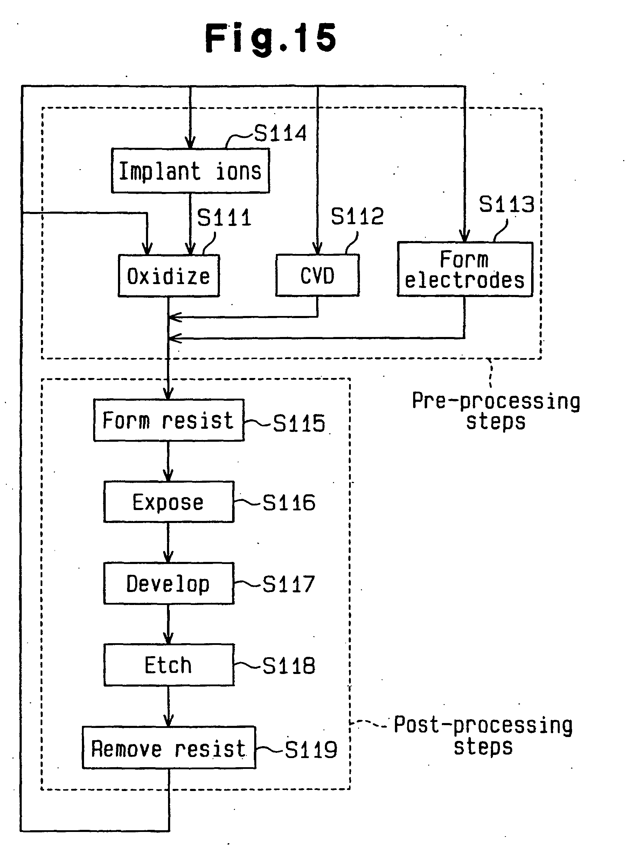

Fig. 15 illustrates an example of detailed flow in step S104 in Fig. 14, when a semiconductor device is concerned. In Fig. 15, in step S111 (oxidizing step), the surface of the wafer W (substrate) is oxidized. In step S112 (CVD step), an insulating film is formed on the surface of the wafer W. In step S113 (electrode forming step), electrodes are formed on the wafer W through vapor deposition. In step S114 (ion implanting step), ions are implanted into the wafer W. Each of the foregoing steps forms part of pre-processing steps at each stage of wafer processing, and are selected and performed as required at each stage.

At each stage of the wafer process, the foregoing pre-processing steps, when finished, are followed by post-processing steps in the following manner. In the post-processing steps, first, in step S115 (resist forming step), a photo-sensitive material such as a photoresist is applied on the wafer W. Subsequently, in step S116 (exposing step), the circuit pattern on the reticle R is transferred onto the wafer W by the lithography system (exposure apparatus 31) previously described. Next, in step S117 (developing step), the exposed wafer W is developed, and in step S118 (etching step), exposed members are etched away except for those portions in which the resist remains. Then, in step S119 (resist removing step), the resist is removed as it is no longer needed after the etching.

Multiple circuit patterns are formed on the wafer W by repeating these pre-processing steps and post-processing steps.

With the use of the device manufacturing apparatus described above, the aforementioned exposure apparatus 31 used at the exposure step (step S116) can accomplish improved resolution by the exposure light EL in the vacuum ultraviolet range, and highly accurate control for exposure amount. Consequently, it is possible to produce highly integrated devices having a minimum line width of approximately 0.1 µm with good yield.

## Claims

1. An optical element holding device (69) including a holder (62) for holding a periphery of an optical element (60), **characterized in that** the holder holds the optical element such that an optical axis (AX') of the optical element is oriented in the horizontal direction or in an oblique direction, and such that a plane (P1) passing through a position for holding the optical element and extending in a direction intersecting the optical axis of the optical element substantially passes through the center of gravity (Gc) of the optical element.

2. The optical element holding device according to claim 1, **characterized in that** at least three of the holders are arranged at substantially equal intervals along the periphery of the optical element.

3. The optical element holding device according to claim 2, **characterized in that** the holders are arranged at positions rotationally symmetric to the optical axis of the optical element.

4. The optical element holding device according to claim 2 or 3, **characterized in that** the holders are arranged at positions symmetric to a plane which includes the optical axis of the optical element and extends in the gravity direction.

5. The optical element holding device according to claim 1, **characterized in that** the position for holding the optical element includes a flange formed on the periphery of the optical element.

6. The optical element holding device according to claim 5, **characterized in that** the plane (P1) is positioned between flange surfaces parallel with each other, the flange surfaces defining the flange.

7. The optical element holding device according to claim 6, **characterized in that** the plane (P1) is positioned halfway between the flange surfaces.

8. The optical element holding device according to claim 1, **characterized in that** the optical element is a reflective mirror.

9. A barrel (37) for holding a plurality of optical elements, **characterized in that** at least one of the plurality of optical element is held by the optical element holding device (69) according to any of claims 1 to 8.

10. An exposure apparatus (31) for transferring an image of a pattern formed on a mask onto a substrate (W) through a projection optical system (35), **characterized in that** the projection optical system includes the barrel (37) according to claim 9.

11. A method of manufacturing a micro-device **characterized by** manufacturing the micro-device using the exposure apparatus (31) according to claim 10.
